# EUROPÄISCHE PATENTANMELDUNG

(11) **EP 1 158 364 A2**
(43) Veröffentlichungstag der Anmeldung: **28.11.2001**
(21) Anmeldenummer: 01110297.7
(22) Anmeldetag: 26.04.2001
(51) Int. Cl.: G03F 7/033, C08F 287/00, C08L 53/02

(54) **Fotopolymerisierbare Flexodruckelemente mit SIS/SBS-Gemischen als Bindemittel zur Herstellung von Flexodruckformen**

(30) Priorität: 03.05.2000 DE 10021196
(71) Anmelder: BASF Drucksysteme GmbH, 70469 Stuttgart (DE)
(72) Erfinder: Knöll, Rolf, Dr., 69469 Weinheim (DE)
(74) Vertreter: Wicke, Reinhard, Dr.

(57) **Zusammenfassung**

Fotopolymerisierbare Zusammensetzung, die ein Gemisch aus thermoplastisch elastomeren SIS- und SBS-Blockcopolymeren als Bindemittel, ethylenisch ungesättigte Monomere, Weichmacher und Fotoinitiator enthält. Fotopolymerisierbare Flexodruckelemente, deren fotopolymerisierbare Schicht diese Zusammensetzung enthält. Verwendung derartiger fotopolymerisierbarer Flexodruckelemente zur Herstellung von Flexodruckformen.

## Beschreibung

Die Erfindung betrifft eine fotopolymerisierbare Zusammensetzung, die ein Gemisch aus thermoplastisch elastomeren SIS- und SBS-Blockcopolymeren als Bindemittel, ethylenisch ungesättigte Monomere, Weichmacher und Fotoinitiator enthält. Sie betrifft weiterhin fotopolymerisierbare Flexodruckelemente, deren fotopolymerisierbare Schicht die besagte fotopolymerisierbare Zusammensetzung enthält sowie die Verwendung derartiger fotopolymerisierbarer Flexodruckelemente zur Herstellung von Flexodruckformen.

Thermoplastisch elastomere Blockcopolymere finden seit geraumer Zeit Verwendung zur Herstellung von fotopolymerisierbaren Flexodruckelementen. So offenbaren beispielsweise DE 22 15 090 oder US 4,323,636 fotoempfindliche Zusammensetzungen aus Bindemittel, ethylenisch ungesättigten Monomeren und Fotoinitiator, bei denen als Bindemittel entweder Polystyrol-Polybutadien-Polystyrol-Blockcopolymere (SBS) oder Polystyrol-Polyisopren-Polystyrol-Blockcopolymere (SIS) eingesetzt werden. Derartige Blockcopolymere können vorteilhaft durch Schmelzextrusion verarbeitet werden, so dass aufwendige Gießprozesse vermieden werden. Weiterhin sind sie billig und kommerziell leicht erhältlich. Wenngleich häufig auch andere (Co)Polymere als Bindemittel vorgeschlagen worden sind, so enthalten doch heutzutage fast alle kommerziell erhältlichen, organisch entwickelbaren fotopolymerisierbaren Flexodruckelemente thermoplastisch elastomere Blockcopolymere als Bindemittel.

Zur Herstellung von kommerziell erhältlichen fotopolymerisierbaren Flexodruckelementen werden bislang nur Blockcopolymere entweder vom SBS-Typ oder vom SIS-Typ eingesetzt. Die für die Herstellung von fotopolymerisierbaren Flexodruckelementen einsetzbaren SIS- und SBS-Blockcopolymere sind im Regelfalle nicht miteinander verträglich und neigen zur Entmischung. Die fotopolymerisierbaren Gemische werden durch derartige Entmischungsprozesse trüb und sind zur Herstellung qualitativ hochwertiger Flexodruckformen ungeeignet.

Flexodruckformen auf Basis von SIS-Blockcopolymeren bzw. von SBS-Blockcopolymeren weisen jeweils ganz charakteristische Vor- und Nachteile auf. SIS-Kautschuke sind weicher und plastischer als SBS-Kautschuke. Sie eignen sich daher ganz besonders zur Herstellung weicherer Flexodruckplatten. Flexodruckformen auf Basis von SIS-Kautschuken neigen jedoch zur Bildung von Rissen unter der Einwirkung von Ozon. Daher werden den Rezepturen üblicherweise Ozonschutzwachse, wie bspw. ausgewählte Paraffine oder Mikrowachse zugesetzt. Derartige Ozonschutzwachse bilden einen unpolaren Schutzfilm auf der Oberfläche der Flexodruckform, der sich insbesondere beim Druck mit wasserbasierenden Druckfarben nachteilig auf die Farbübertragung auswirken kann. Weiterhin weisen Flexodruckformen auf Basis von SIS-Kautschuken üblicherweise eine höhere Oberflächenklebrigkeit und einen höheren Abrieb auf als solche auf SBS-Basis.

SBS-Kautschuke können ohne den Zusatz von Ozonschutzwachsen eingesetzt werden. Daher weisen Flexodruckformen auf Basis von SBS-Kautschuken eine sehr gute Farbübertragung speziell mit wasserbasierenden Druckfarben auf. Die Oberfläche von Flexodruckformen auf Basis von SBS-Kautschuken ist weniger klebrig und weist eine höhere Abriebfestigkeit auf, was sich insbesondere beim Druck auf rauen Bedruckstoffen sehr vorteilhaft bemerkbar macht. Nachteilig an Druckformen mit SBS-Kautschuken ist jedoch deren größere Härte. Um weiche Flexodruckformen zu erhalten, werden größere Mengen an Weichmacher eingesetzt als bei Platten auf SIS-Basis. Die Menge an Weichmacher in der Rezeptur kann jedoch naturgemäß nicht beliebig gesteigert werden, ohne andere Eigenschaften nachteilig zu beeinflussen. Störend ist auch die Neigung von SBS-Druckplatten zur Anisotropie. Darunter ist zu verstehen, dass im Zuge der üblichen Herstellung durch Schmelzextrusion und Kalandrieren richtungsabhängige mechanische, optische und drucktechnische Eigenschaften erhalten werden. Da Druckplatten nicht immer in gleicher Orientierung auf den Druckzylinder aufgespannt werden, kommt es insbesondere beim Mehrfarbdruck zu Störungen. Eine zu hohe Anisotropie ist überhaupt nicht mehr tolerabel.

Es wäre wünschenswert, über eine Flexodruckform mit den Vorteilen der SBS-Kautschuke zu verfügen, ohne die Nachteile der zu großen Härte und Anisotropie in Kauf nehmen zu müssen. Aufgabe der Erfindung war es daher, fotopolymerisierbare Flexodruckelemente zur Herstellung derartiger Flexodruckformen bereitzustellen.

Überraschenderweise wurde gefunden, dass sich dieses Ziel durch die Verwendung von bestimmten SBS-Kautschuken im Gemisch mit SIS-Kautschuken erreichen lässt. Dies war umso überraschender, als SIS- und SBS-Kautschuke üblicherweise nicht miteinander verträglich sind.

Dementsprechend wurden fotopolymerisierbare Zusammensetzungen gefunden, die ein Gemisch aus bestimmten thermoplastisch elastomeren SIS- und SBS-Blockcopolymeren als Bindemittel, ethylenisch ungesättigte Monomere, Weichmacher und Fotoinitiator enthalten. Weiterhin wurden fotopolymerisierbare Flexodruckelemente gefunden, deren fotopolymerisierbare Schicht diese Zusammensetzung enthält, sowie die Verwendung derartiger fotopolymerisierbarer Flexodruckelemente zur Herstellung von Flexodruckformen.

Als SIS-Komponente werden die üblichen, für die Herstellung von fotopolymerisierbaren Flexodruckelementen geeigneten, thermoplastisch elastomeren SIS-Blockcopolymere eingesetzt. Der Polystyrolgehalt derartiger Polymerer beträgt üblicherweise weniger als 40 Gew.-%. Vorzugsweise eingesetzt werden Blockcopolymere mit einem Polystyrolgehalt zwischen 10 und 35 Gew.-%, besonders bevorzugt werden Blockcopolymere mit einem Polystyrolgehalt zwischen 10 und 20 Gew.-% eingesetzt. Das scheinbare Molekulargewicht der SIS-Blockcopolymere liegt üblicherweise zwischen 80.000 und 300.000, bevorzugt zwischen 100.000 und 250.000. Mit der Bezeichnung "scheinbares Molekulargewicht", wie sie in der vorliegenden Schrift verwendet wird, ist das mittlere Molekulargewicht M_{w} gemeint, das mit Hilfe der Gelpermeationschromatographie (GPC) unter Verwendung von Polystyrol-Standards bestimmt wird. Bei den SIS-Blockcopolymeren kann es sich sowohl um lineare Blockcopolymere handeln oder auch um radiale Blockcopolymere. Üblicherweise handelt es sich um Dreiblockcopolymere vom A-B-A-Typ, es kann sich aber auch um Zweiblockpolymere vom A-B-Typ handeln, oder um solche mit mehreren alternierenden elastomeren und thermoplastischen Blöcken, z.B. A-B-A-B-A. Es können auch Gemische zweier oder mehrerer unterschiedlicher SIS-Blockcopolymerer eingesetzt werden. Handelsübliche SIS-Blockcopolymere enthalten vielfach einen SI-Zweiblockanteil. Der SI-Zweiblockanteil liegt vorzugsweise zwischen 0 und 40 Gew.-%, besonders bevorzugt zwischen 10 und 30 Gew.-%.

Bevorzugt handelt es sich bei den eingesetzten SIS-Blockcopolymeren um lineare Blockcopolymere.

Bei der erfindungsgemäßen, fotopolymerisierbaren Zusammensetzung wird das SIS-Blockcopolymere im Gemisch mit einem oder mehreren thermoplastischen elastomeren SBS-Blockcopolymeren eingesetzt, die mit dem SIS-Blockcopolymeren verträglich sind. Unter Verträglichkeit im Sinne dieser Erfindung soll verstanden werden, dass sich die SBS- und SIS-Blockcopolymere zusammen mit den anderen Komponenten der fotopolymerisierbaren Mischung zu einer klaren, ungetrübten, aktinisches Licht nicht streuenden Mischung verarbeiten lassen. Eintrübungen, Schlieren oder dergleichen in der fotopolymerisierbaren Schicht stören den Prozess der Fotopolymerisation, so dass entweder überhaupt keine, oder zumindest nur Flexodruckformen schlechter Qualität erhalten werden.

Bei den SBS-Blockcopolymeren kann es sich um lineare Dreiblockcopolymere, Zweiblockcopolymere, um Polymere mit mehreren elastomeren und thermoplastischen Blöcken, um radiale oder quasi-radiale Blockcopolymere, sowie um Gemische davon handeln. Der Polystyrolgehalt der SBS-Blockcopolymere liegt zwischen 5 und 25 Gew.-%. Bei höheren Polystyrolgehalten werden mit den weiter oben beschriebenen SIS-Blockcopolymeren keine transparenten Mischungen mehr erhalten. Bevorzugt liegt der Polystyrolgehalt des SBS-Blockcopolymers zwischen 10 und 25 Gew.-%, ganz besonders bevorzugt zwischen 15 und 20 Gew.-%. Das scheinbare Molekulargewicht der SBS-Blockcopolymeren liegt üblicherweise zwischen 50.000 und 300.000. Bevorzugt eingesetzt werden SBS-Blockcopolymere mit einem scheinbaren Molekulargewicht zwischen 100.000 und 300.000, besonders bevorzugt sind SBS-Blockcopolymere mit einem scheinbaren Molekulargewicht zwischen 200.000 und 250.000. Die Polystyrolblöcke weisen ein scheinbares Molekulargewicht zwischen 5.000 und 50.000 auf. Bevorzugt liegt das scheinbare Molekulargewicht der Polystyrolblöcke zwischen 7.000 und 35.000, besonders bevorzugt zwischen 9.000 und 17.000. Vorteilhaft wird das scheinbare Molekulargewicht der Polystyrolblöcke so gewählt, dass es in etwa dem der Polystyrolblöcke der weiter oben beschriebenen SIS-Blockcopolymeren entspricht. Die Butadieneinheiten in den Polybutadienblöcken können entweder 1,4- oder aber 1,2-verknüpft sein. Der Vinylbindungsanteil der erfindungsgemäß eingesetzten SBS-Blockcopolymere liegt zwischen 5 und 70 %, vorzugsweise im Bereich zwischen 35 und 65 %, besonders bevorzugt im Bereich zwischen 50 und 60 %. Geeignete SBS-Blockcopolymere sind beispielsweise in EP-A 696 761 offenbart.

Bevorzugt handelt es sich bei den eingesetzten SBS-Blockcopolymeren um radiale oder verzweigte Blockcopolymere der allgemeinen Formel (SB)ₓ(B)_{y}Z, wobei S und B in bekannter Art und Weise für Styrol- bzw. Butadienblöcke stehen, und Z für ein polyfunktionelles Kupplungsagens, welches mehrere Blöcke miteinander verknüpft. (SB)-Einheiten sind üblicherweise über den Butadienblock an das Kupplungsagens Z angebunden. x steht in der Formel für eine ganze Zahl von 2 bis 20 und y für 0 oder eine ganze Zahl von 1 bis 20. Bei geeigneten radialen SBS-Blockcopolymeren kann es sich um symmetrisch aufgebaute radiale Blockcopolymere handeln, bei denen y=0 ist, beispielsweise um Polymere der Formel (SB)₄Z oder (SB)₂Z. Bevorzugt sind aber radiale Blockcopolymere, die sowohl über (SB)- wie über (B)-Arme verfügen. Besonders geeignet sind Polymere der allgemeinen Formel (SB)₂(B)₂Z. Radiale Blockcopolymere sind beispielsweise von EP-A 696 761 offenbart, und sind auch kommerziell erhältlich.

Das Gewichtsverhältnis SBS/SIS-Blockcopolymer beträgt 70/30 bis 10/90. Ist das Verhältnis der Blockcopolymere größer als 70/30, so werden zu harte und zu spröde Flexodruckformen erhalten, die beim Biegen brechen können. Ist das Verhältnis der Blockcopolymere kleiner als 10/90, so ist die Plattenoberfläche klebrig, und weiterhin muss mit Ozonschutzwachs gearbeitet werden. Bevorzugt beträgt das SBS/SIS-Verhältnis 60/40 bis 40/60.

Die erfindungsgemäßen Zusammensetzungen enthalten weiterhin in bekannter Weise polymerisierbare Verbindungen, beziehungsweise Monomere. Die Monomeren sollen mit den Bindemitteln verträglich sein und mindestens eine polymerisierbare, ethylenisch ungesättigte Doppelbindung aufweisen. Geeignete Monomere haben im allgemeinen einen Siedepunkt von mehr als 100 °C bei Atmosphärendruck und ein Molekulargewicht von bis zu 3.000 g/mol, vorzugsweise bis zu 2.000 g/mol. Als besonders vorteilhaft haben sich Ester oder Amide der Acrylsäure oder Methacrylsäure mit mono-oder polyfunktionellen Alkoholen, Aminen, Aminoalkoholen oder Hydroxyethern und -estern, Styrol oder substituierte Styrole, Ester der Fumar- oder Maleinsäure oder Allylverbindungen erwiesen. Beispiele für geeignete Monomere sind Butylacrylat, 2-Ethylhexylacrylat, Laurylacrylat, 1,4-Butandioldiacrylat, 1,6-Hexandioldiacrylat, 1,6-Hexandioldimethacrylat, 1,9-Nonandioldiacrylat, Trimethylolpropantriacrylat, Dioctylfumarat und N-Dodecylmaleimid.

Als Initiatoren für die Fotopolymerisation sind unter anderem Benzoin oder Benzoinderivate, wie α-Methylbenzoin oder Benzoinether, Benzilderivate, wie Benzilketale, Acylarylphosphinoxide, Acylarylphosphinsäureester, Mehrkernchinone oder Benzophenone geeignet.

Die erfindungsgemäßen, fotopolymerisierbaren Zusammensetzungen enthalten in der Regel 50 bis 90 Gew.-% der Bindemittelmischung aus SIS- und SBS-Blockcopolymeren bzgl. der Summe aller Bestandteile. Vorzugsweise werden 60 bis 85 Gew.-% des Bindemittels eingesetzt. Die Menge der polymerisierbaren Monomeren liegt im Bereich von 4,9 bis 30 Gew.-%, bevorzugt zwischen 4,9 und 20 Gew.-%. Die Menge an Photoinitiator beträgt 0,1 bis 5 Gew.-%.

Die fotopolymerisierbaren Gemische enthalten darüber hinaus mindestens einen Weichmacher. Es können auch Gemische verschiedener Weichmacher eingesetzt werden. Neben ihrer eigentlichen Funktion zur Einstellung eines gewünschten Härtebereiches tragen die Weichmacher auch vorteilhaft zu einer optimalen Verträglichkeit der SIS- und SBS-Kautschuke bei. Beispiele für geeignete Weichmacher sind modifizierte oder unmodifizierte Naturöle und -harze, paraffinische Mineralöle, Alkyl-, Alkenyl-, Arylalkyl- oder Arylalkenylester von Säuren, wie Alkansäuren oder Arylcarbonsäuren. Bevorzugt werden synthetische Oligomere oder Harze wie Oligostyrol, oligomere Styrol-Butadien-Copolymere, oligomere α-Methylstyrol/p-Methylstyrol-Copolymere, flüssige Oligobutadiene, flüssige Oligoisoprene oder flüssige oligomere Acrylnitril-Butadien-Copolymere eingesetzt. Derartige Oligomere weisen typischerweise ein Molekulargewicht zwischen 500 und 5.000 g/mol auf.

Als Weichmacher ganz besonders bevorzugt sind Polybutadienöle. Die Menge an Weichmacher liegt in der Regel zwischen 5 und 40 Gew.-% bzgl. der Summe aller Bestandteile des fotopolymerisierbaren Gemischs. Bevorzugt beträgt die Menge zwischen 8 und 35 Gew.-%, besonders bevorzugt zwischen 10 und 30 Gew.-%.

Die fotopolymerisierbaren Gemische können ferner übliche Hilfsstoffe enthalten, vor allem Inhibitoren für die thermisch initiierte Polymerisation, Farbstoffe, Pigmente, fotochrome Zusätze, Antioxidantien oder Extrusionshilfsmittel. Ihre Menge liegt im allgemeinen unter 10 Gew.-% bzgl. der Summe aller Bestandteile der fotopolymerisierbaren Zusammensetzung.

Die erfindungsgemäße, fotopolymerisierbare Zusammensetzung kann zur Herstellung von fotopolymerisierbaren Flexodruckelementen eingesetzt werden. Derartige fotopolymerisierbare Flexodruckelemente umfassen eine gegebenenfalls mit einer Haftschicht auf einem dimensionsstabilen Träger aufgebrachte fotopolymerisierbare, reliefbildende Schicht.

Bei den erfindungsgemäßen fotopolymerisierbaren Flexodruckelementen handelt es sich einerseits um Platten. Als dimensionsstabile Träger hierfür kommen insbesondere dimensionsstabile Trägerfolien, beispielsweise Polyesterfolien, insbesondere Polyethylenterephthalatfolien oder Polyethylennaphthalatfolien in Frage. Diese Trägerfolien sind im allgemeinen zwischen 50 und 500 µm, vorzugsweise zwischen 75 und 400 µm, beispielsweise ca. 125µm dick. Der Schichtträger kann mit einer weichelastischen Unterschicht unterlegt sein. Es kann sich aber auch um Flexo-Sleeves handeln, bei denen als Träger konische oder zylindrische Röhren aus Metallen oder Kunststoffen eingesetzt werden.

Die Dicke der fotopolymerisierbaren reliefbildenden Schicht richtet sich in erster Linie nach dem Verwendungszweck der Druckformen. So variiert die Dicke im allgemeinen von 0,1 bis 7 mm, vorzugsweise 0,7 bis 6,5 mm. Sie wird vom Fachmann gemäß den Anforderungen der jeweils gewünschten Anwendung gewählt.

Die fotopolymerisierbare Schicht kann hergestellt werden, indem man in bekannter Art und Weise die Bindemittel und die weiteren Bestandteile der Schicht in einem geeigneten Lösungsmittel oder Lösungsmittelgemisch löst, die Lösung auf den Träger aufgießt und das Lösungsmittel verdampft. Bevorzugt wird das fotopolymerisierbare Flexodruckelement in bekannter Art und Weise durch Schmelzextrusion bei erhöhten Temperaturen und Kalandrieren herstellt, wobei die besonderen Vorteile der Erfindung zur Geltung kommen: Während man im Zuge dieses Verfahrens bei konventionellen SBS-Kautschuk-haltigen Rezepturen üblicherweise anisotrope Produkte erhält, können beim erfindungsgemäßen Einsatz von SIS/SBS-Gemischen Produkte ohne oder zumindest fast ohne Anisotropie erhalten werden.

Die fotopolymerisierbare Schicht kann auch aus mehreren Teilschichten aufgebaut werden. Diese Teilschichten können von gleicher, in etwa gleicher oder von unterschiedlicher stofflicher Zusammensetzung sein. Die Herstellung der aus Teilschichten aufgebauten Schicht kann beispielsweise nach der in der EP-A 0 362 641 angegebenen Methode erfolgen.

Das fotopolymerisierbare Flexodruckelement wird üblicherweise in bekannter Art und Weise gegen mechanische Beschädigungen durch eine Schutzfolie geschützt, die sich auf der fotopolymerisierbaren Schicht befindet. Sie kann je nach Verwendungszweck optional noch weitere Schichten umfassen.

Ein Beispiel für eine weitere Schicht ist eine im Entwickler für die fotopolymerisierbare Schicht lösliche Deckschicht (auch als "release-layer" bekannt) zwischen der fotopolymerisierbaren Schicht und der Schutzfolie. Sie besteht häufig aus geeigneten Polyamiden und erleichtert das Abziehen der Schutzfolie vor dem Gebrauch der Druckform, sowie das Auflegen des fotografischen Negativs zur Bebilderung.

Ein weiteres Beispiel ist eine vergleichsweise dünne, ebenfalls fotopolymerisierbare Oberschicht auf der fotopolymerisierbaren Schicht (auch als "top-layer" bekannt). Eine derartige Oberschicht ist beispielsweise in EP-A 084 851 offenbart. Dieser zweischichtige Aufbau hat den Vorteil, dass die Eigenschaften der Oberfläche der Druckform, wie beispielsweise Farbübertragung verändert werden können, ohne die flexotypischen Eigenschaften der Druckform wie beispielsweise Härte oder Elastizität zu beeinflussen. Oberflächeneigenschaften und Schichteigenschaften können also unabhängig voneinander verändert werden, um ein optimales Druckergebnis zu erreichen.

Weiterhin sei eine IR-ablative Schicht genannt. Diese kann sich auf der fotopolymerisierbaren Schicht befinden oder auch - falls vorhanden - auf der Oberschicht. Derartige Schichten umfassen üblicherweise ein Bindemittel und Ruß. Sie dienen zur direkten, digitalen Bebilderung des fotopolymerisierbaren Flexodruckelementes mittels IR-Laser. Beispiele für derartige Schichten finden sich in EP-A 767 407 oder in EP-A 654 150.

Die erfindungsgemäßen fotopolymerisierbaren Flexodruckelemente können in an sich bekannter Art und Weise zur Herstellung von Flexodruckformen eingesetzt werden. Die Herstellung der Flexodruckformen kann dabei einmal in klassischer Arbeitsweise durch Vorbelichten, Abziehen der Schutzfolie falls vorhanden, Auflegen eines fotografischen Negativs, bildmäßiges Belichten mit aktinischem Licht, Entwickeln, Trocknen und optional Nachbehandlung erfolgen. Alternativ kann die Herstellung über digitale Bebilderung erfolgen. Hierzu wird ein erfindungsgemäßes, fotopolymerisierbares Flexodruckelement, das über eine IR-ablative Schicht verfügt, eingesetzt. Die Herstellung der Flexodruckformen umfasst nun die Schritte Vorbelichten, Abziehen der Schutzfolie falls vorhanden, bildmäßiges Beschreiben der IR-ablativen Schicht, bildmäßiges Belichten mit aktinischem Licht, Entwickeln, Trocknen und optional Nachbehandlung. Nähere Einzelheiten zu beiden Verfahren sind dem Fachmann bekannt und beispielsweise in EP-A 992 849 offenbart.

Die unter Verwendung der erfindungsgemäßen, fotopolymerisierbaren Flexodruckelemente erhaltenen Flexodruckformen weisen die typischen Vorteile der SBS-Kautschuk enthaltenden Flexodruckformen auf, nämlich hohe Ozonrissbeständigkeit und hohe Abriebfestigkeit. Sie können ohne Ozonschutzwachse eingesetzt werden. Darüber hinaus weisen sie bei gleicher Weichmachermenge eine vorteilhaft geringere Härte und außerdem keine Anisotropie auf.

Die folgenden Beispiele sollen die Erfindung näher erläutern, ohne dass dadurch der Umfang der Erfindung eingeschränkt wird.

Die beschriebenen Messwerte wurden wie folgt ermittelt:

| Messwert | Messvorschrift |
|---|---|
| Anisotropiefaktor | Von einer mindestens für 20 Minuten voll- flächig mit aktinischem Licht belichteten Flexodruckplatte wird ein knochenförmiger Prüfkörper ausgestanzt. Dieser Prüfkörper wird in einer Zug-Dehnungs-Prüfmaschine (Zwick) eingespannt. Es wird eine Zug- Dehnungs-Messung durchgeführt. Der Aniso- tropiefaktor ergibt sich aus dem Quotien- ten aus der Reisskraft längs zur Reiss- kraft quer bei einer Dehnung von 125 %. Mit längs und quer ist die Extrusions- richtung gemeint. Als anisotrop werden Flexodruckklischees bezeichnet, wenn der Anisotropiefaktor größer als 1,2 ist. |
| Rohschichtplastizität | Die Rohschichtplastizität wird an fotopo- lymerisierbaren Flexodruckelementen nach Abziehen der Schutzfolie bestimmt. Dabei drückt ein definierter Messstempel mit einem definierten Auflagegewicht für eine bestimmte Zeit in die Rohschicht. Gemes- sen wird die Schichtdickendifferenz vor Belastung zu nach 10 Minuten Belastung mit dem Messstempel (Angabe in Prozent, umgekehrtes Vorzeichen). |
| Shore A-Härte | Die Bestimmung der Klischeehärte von fo- topolymeren Flexodruckplatten erfolgt mit Hilfe eines Shore A-Härtemeßgerätes in Anlehung an DIN 53505. Über die Eindring- tiefe eines definierten Messstempels in die zu messende Probe wird die Härte der Probe, angegeben in 5Shore A, bestimmt. In Abweichung zur DIN-Norm 53505 werden allerdings keine 6 mm dicken Schichten verwendet. Die Klischeehärte wird direkt am Klischee gemessen. |

Bei den Beispielen und Vergleichsbeispielen wurde nach folgender, allgemeiner Versuchsvorschrift vorgegangen:
A) Herstellung des fotopolymerisierbaren Gemischs:
   Ein Gemisch aus Bindemitteln, ethylenisch ungesättigten Monomeren, Fotoinitiator, Weichmacher und Farbstoff wurde in einem Zweischneckenextruder (Werner & Pfleiderer ZSK 53) mit einem Durchsatz von 30 kg/h bei einer Massetemperatur zwischen 160 und 170 °C extrudiert und durch eine Breitschlitzdüse ausgetragen. Die aus der Düse ausgetragene Schmelze wurde in den Spalt eines Zweiwalzenkalanders eingeführt. Beide Walzen waren auf 80 °C beheizt.
   Über die obere Kalanderwalze wurde eine mit einem Haftlack beschichtete, 125 µm dicke Polyethylenterephthalat-Folie (Mylar® ) eingeführt, über die untere Kalanderwalze eine mit einer aus Polyamid bestehenden release-layer beschichtete, 125 µm dicke Polyethylenterephthalat-Folie (Mylar® ).
B) Herstellung des Druckklischees:
   Nach einer Woche Lagerzeit wurden die Rohplatten zu Klischees verarbeitet. Folgende Verarbeitungsschritte wurden durchgeführt:
   a Vollflächige rückseitige Belichtung mit UV-Licht (Belichter FIII, BASF, 35 s),
   b Abziehen der Schutzfolie,
   c Auflegen eines nyloflex® FAR II-Testfilms (BASF),
   d Hauptbelichtung unter der Vakuumfolie (Belichter FIII, BASF, 4-18 min in 2-Minuten-Schritten)
   e Auswaschen der Platte (Durchlaufwascher Combi FII, BASF, Auswaschgeschwindigkeit 150 mm/min, Auswaschmittel: nylosolv® II, BASF, 30 °C, Relieftiefe 1000 µm)
   f 3 Stunden Trocknen bei 65 °C
   g Nachbelichtung (UVA, Belichter FIII, BASF, 15 Minuten)
   h Nachbehandeln mit UVC-Licht (Nachbehandlungsgerät FIII, BASF, 15 Minuten)

Das Testklischee wurde ausgewertet. Beurteilt wurde, bei welcher Belichtungszeit die Positiv-Testelemente (freistehender Punkt: 200 µm, Gitter: 55 µm, 2%-Tonwert-Rasterfeld (60L/cm)) auf dem Klischee korrekt ausgebildet waren. Der Zeitpunkt, zu dem alle Positivelemente korrekt ausgebildet sind, wird als Untere Belichtungsgrenze (UBG) bezeichnet, d.h. die Mindestbelichtungsdauer für eine korrekte Abbildung.

Darüber hinaus wurden auch die Negativelemente, d.h. der 400-µm-Negativpunkt und der 2000-µm-Graben beurteilt. Unterschreitet die Tiefe im Negativpunkt 70 µm bzw. im Graben 500 µm, so ist eine korrekte Farbübertragung nicht mehr gewährleistet. Der Zeitpunkt, zu dem mindestens eines der beiden Negativelemente diese Grenzen unterschreitet, wird als Obere Belichtungsgrenze (OBG) bezeichnet. Die Differenz von OBG und UBG ergibt den sog. Belichtungsspielraum (BSR). Für eine praxisgerechte Anwendung der Flexodruckplatte muss der Belichtungsspielraum positiv sein. Ein negativer Belichtungsspielraum bedeutet, dass die feinen Negativelemente bereits zugelaufen sind, während die Positivelemente noch gar nicht richtig durchpolymerisiert sind.

An den Testklischees wurden weiterhin folgende Messgrößen bestimmt: Klischeehärte, Anisotropiefaktor, Ozonrissbeständigkeit.

### Beispiel 1:

Zur Herstellung des lichtempflindlichen Gemisches wurden die in Tabelle 1 aufgeführten Komponenten und Mengen eingesetzt und gemäß der obigen allgemeinen Vorschrift zu einer fotopolymerisierbaren Flexodruckplatte verarbeitet.

| Komponente | Typ | Menge |
|---|---|---|
| SIS-Blockcopolymer | Kraton D-1161, SIS-Blockcopolymer, 15 Gew.-% Polystyrol | 34,247 % |
| SBS-Blockcopolymer | Kraton D-KX222, SBS-Block- copolymer, 18 Gew.-% Polystyrol | 34,247 % |
| Weichmacher | Polyöl 130 (Polybutadienöl) | 20 % |
| Monomer | 1,6 Hexandioldiacrylat | 5 % |
| | 1,6 Hexandioldimethacrylat | 3 % |
| Fotoinitiator | Benzildimethylketal | 2,5 % |
| thermischer Stabilisator | Kerobit TBK | 1,0 % |
| Farbstoff | Neozaponrot 335 | 0,006 % |
| Summe | | 100 % |
| | Verhältnis SBS/SIS | 50/50 |

### Tabelle 1

Es wurde ein glasklares fotopolymerisierbares Flexodruckelement erhalten, das sich hervorragend zu einem Flexodruckklischee verarbeiten ließ.

Die Messwerte sind in Tabelle 3 angegeben.

### Beispiel 2:

Es wurde wie in Beispiel 1 vorgegangen, nur wurde als Weichmacher ein medizinisches Weißöl anstelle von Polyöl 130 verwendet.

Die Messwerte sind in Tabelle 3 zusammengefasst.

### Vergleichsbeipiel 1:

Es wurde wie in Beispiel 1 vorgegangen, nur wurde anstelle von Kraton D-KX222 Kraton D-KX225 eingesetzt (lineares SBS-Blockcopolymeres, 30 Gew.-% Polystyrol).

Das erhaltene fotopolymerisierbare Flexodruckelement war nicht ganz klar und wies einen negativen Belichtungsspielraum auf.

Die Messwerte sind in Tabelle 3 zusammengefasst.

### Vergleichsbeipiel 2:

Es wurde wie in Beispiel 1 vorgegangen, nur wurde anstelle von Kraton D-KX222 Kraton D-KX225 eingesetzt (lineares SBS-Blockcopolymeres, 30 Gew.-% Polystyrol) und anstelle von Polyöl 130 wurde als Weichmacher ein medizinisches Weißöl eingesetzt.

Das fotopolymerisierbare Flexodruckelement wies Schlieren auf. Das erhaltene Klischee war trüb, und die Druckelemente waren so schlecht ausgebildet, dass eine Auswertung nicht möglich war.

### Vergleichsbeispiel 3:

Es wurde wie in Beispiel 1 vorgegangen, jedoch wurde als Bindemittel ausschließlich Kraton D-KX222 (SBS-Blockcopolymeres) ersetzt.

Es wurde ein relativ hartes Klischee mit einer hohen Anisotropie erhalten, welches beim Biegen der Platte durchbrach.

### Vergleichsbeipiel 4:

Es wurde wie in Beispiel 1 vorgegangen, nur betrug das Mischungsverhältnis SBS/SIS-Kautschuk 80/20.

Gegenüber Vergleichsbeispiel 3 war die Anisotropie zwar deutlich verringert, aber immer noch vorhanden. Die Platte brach immer noch, wenn auch mit deutlich verringerter Rissbildungsgeschwindigkeit.

### Beispiel 3:

Es wurde wie in Beispiel 1 vorgegangen, nur betrug das Mischungsverhältnis SBS/SIS-Kautschuk 70/30.

Die Platte wies keine Anisotropie mehr auf und war ohne Bruch biegbar.

### Beispiel 4:

Es wurde wie in Beispiel 1 vorgegangen, nur betrug das Mischungsverhältnis SBS/SIS-Kautschuk 10/90.

### Vergelichsbeispiel 5:

Es wurde wie in Beispiel 1 vorgegangen, jedoch wurde als Bindemittel ausschließlich SIS-Kautschuk eingesetzt.

Die erhaltene Platte wies eine deutliche Klebrigkeit auf und wies nach längerem Einsatz beim Drucken Ozonrisse auf.

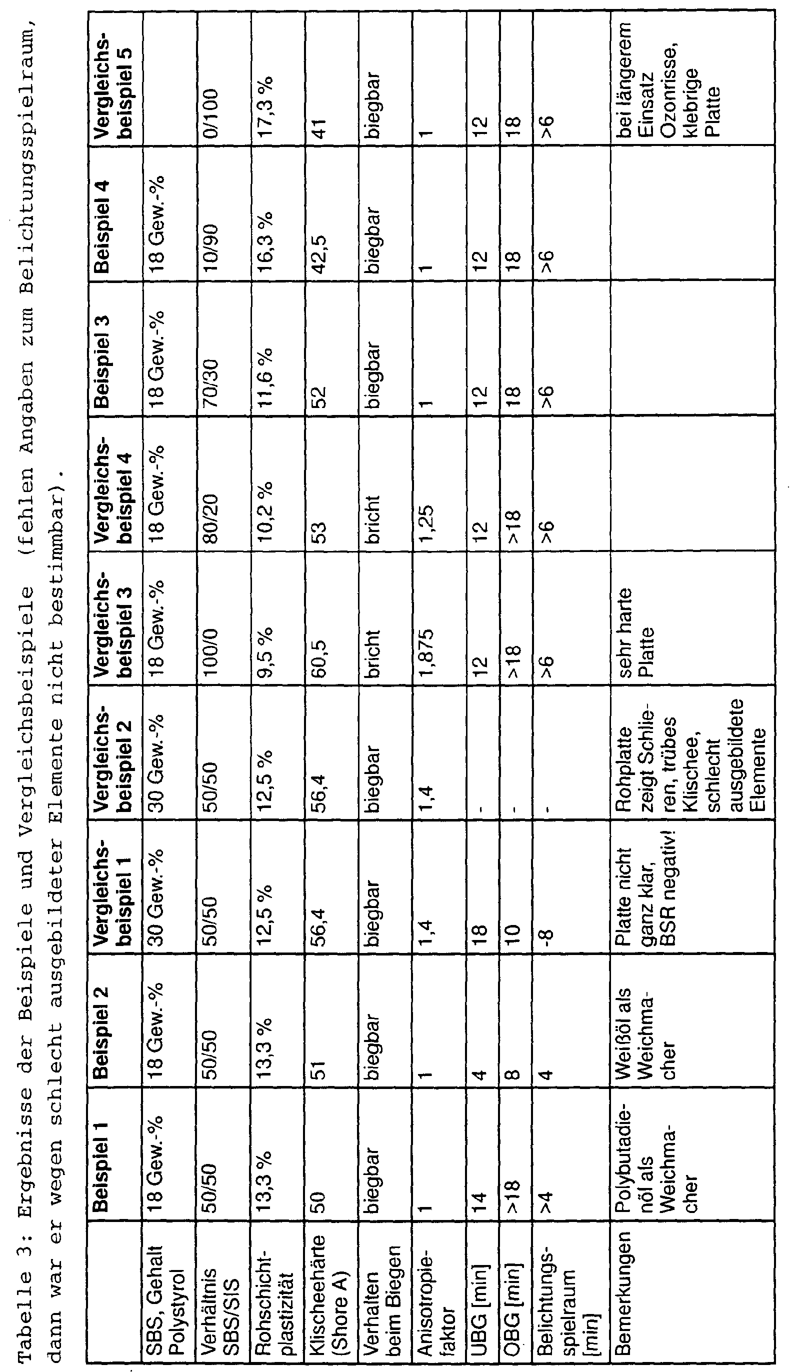

## Patentansprüche

1. Fotopolymerisierbare Zusammensetzung mindestens umfassend mindestens ein thermoplastisch elastomeres SIS-Blockcopolymer mit einem Styrolgehalt von 5 bis 25 Gew. % als Bindemittel, 4,9 bis 30 Gew. % von mindestens einem ethylenisch ungesättigten Monomeren, 5 - 40 Gew. % von mindestens einem Weichmacher, sowie 0,1 bis 5 Gew. % von mindestens einem Fotoinitiator oder Fotoinitiatorsystem, **dadurch gekennzeichnet, dass** das Gemisch
• weiterhin mindestens ein thermoplastisch elastomeres SBS-Blockcopolymer mit einem Styrolgehalt von 5 bis 25 Gew. % sowie einem Vinylbindungsanteil von 35 bis 65 % umfasst,
• das Gewichtsverhältnis SBS-Blockcopolymer/SIS-Blockcopolymer 70/30 bis 10/90 beträgt, und
• dass die fotopolymerisierbare Zusammensetzung 50 bis 90 Gew.-% der Bindemittelmischung aus SIS- und SBS-Blockcopolymeren umfasst.

2. Fotopolymerisierbare Zusammensetzung gemäß Anspruch 1, **dadurch gekennzeichnet, dass** der Vinylbindungsanteil 50 bis 60 % beträgt.

3. Fotopolymerisierbare Zusammensetzung gemäß Anspruch 1 oder 2, **dadurch gekennzeichnet, dass** das Gewichtsverhältnis SBS-Blockcopolymer/SIS-Blockcopolymer 60/40 bis 40/60 beträgt.

4. Fotopolymerisierbare Zusammensetzung gemäß einem der Ansprüche 1 bis 3, **dadurch gekennzeichnet, dass** es sich bei dem Weichmacher um ein Polybutadienöl handelt.

5. Fotopolymerisierbare Zusammensetzung gemäß einem der Ansprüche 1 bis 4, **dadurch gekennzeichnet, dass** das SIS-Blockcopolymeren linear und das SBS-Blockcopolymer radial aufgebaut ist.

6. Fotopolymerisierbare Flexodruckform mindestens umfassend einen dimensionsstabilen Schichtträger und eine darauf aufgebrachte fotopolymerisierbare Schicht, **dadurch gekennzeichnet, dass** die fotopolymerisierbare Schicht eine fotopolymerisierbare Zusammensetzung nach einem der Ansprüche 1 bis 5 umfasst.

7. Verwendung von fotopolymerisierbaren Flexodruckformen nach Anspruch 6 zur Herstellung von Flexodruckformen.
